(19) **Europäisches Patentamt / European Patent Office / Office européen des brevets**

(11) **EP 2 970 692 B1**

(12) # EUROPEAN PATENT SPECIFICATION

(45) Date of publication and mention
of the grant of the patent:
**19.04.2017   Bulletin 2017/16**

(21) Application number: **14717591.3**

(22) Date of filing: **13.03.2014**

(51) Int Cl.:
***C09D 5/00*** *(2006.01)*

(86) International application number:
**PCT/US2014/025445**

(87) International publication number:
**WO 2014/159914 (02.10.2014 Gazette 2014/40)**

(54) **THERMO-RESPONSIVE ASSEMBLY AND METHODS FOR MAKING AND USING THE SAME**

WÄRMEEMPFINDLICHE ZUSAMMENSETZUNG UND VERFAHREN ZUR HERSTELLUNG UND
VERWENDUNG DAVON

ENSEMBLE THERMOSENSIBLE ET PROCÉDÉS POUR SA FABRICATION ET SON UTILISATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.03.2013   US 201361780262 P**

(43) Date of publication of application:
**20.01.2016   Bulletin 2016/03**

(73) Proprietor: **SABIC Global Technologies B.V.
4612 PX  Bergen op Zoom (NL)**

(72) Inventors:
• **PICKETT, James, Edward
Niskayuna, NY 12309 (US)**

• **SMIGELSKI, Paul, Michael
Niskayuna, NY 12309 (US)**
• **WATKINS, Vicki, Herzl
Alplaus, NY 12008 (US)**
• **TAKEMORI, Michael, Teruki
Niskayuna, NY 12309 (US)**

(74) Representative: **Modiano, Micaela Nadia et al
Modiano & Partners
Thierschstrasse 11
80538 München (DE)**

(56) References cited:
**EP-A1- 1 544 921        EP-A1- 2 161 759
US-A1- 2008 008 858     US-A1- 2012 024 353
US-B1- 6 204 443**

**Description**

TECHNICAL FIELD

Disclosed herein are thermo-responsive assemblies that can help control stagnation temperatures in solar panels used to provide hot water in domestic and commercial entities.

BACKGROUND

Solar panels can be efficient and cost-effective sources of hot water for domestic and commercial hot water heating as well as for space heating. Plastic solar panels or modules commonly are constructed from a transparent polymer glazing sheet (e.g., polycarbonate multi-wall sheet), a black plastic absorber sheet with extruded water channels (e.g., polysulfone or polyphenylene ether (PPE) blend multi-wall sheet), an insulating backing, and if necessary water manifolds and frame pieces. Since the absorber layer is insulated from both the front and back, temperatures much higher than ambient can be attained. Modules are commonly designed to produce water as hot as 70 degrees Celsius (°C) to 80°C.

There are sometimes periods in which the module is exposed to the sun and water or other heat transfer fluid is not flowing through the absorber sheet, and the module can overheat. This is termed "stagnation conditions." Module temperatures in excess of 140°C or even 150°C are possible during these stagnation conditions. During stagnation conditions, the heat deflection temperature of the plastic components can be exceeded, resulting in irreversible buckling, thermal expansion beyond design limits, and/or other thermally-induced effects that can lead to failure of the unit. Using only polymers capable of withstanding such temperatures greatly increases the cost of the module. Control of stagnation temperature therefore is an important design requirement for efficient, cost-effective plastic solar modules.

Accordingly, there is a need for a thermo-responsive assembly that can help control stagnation temperatures to provide an efficient, cost-effective plastic solar module.

SUMMARY

Disclosed, in various embodiments, are thermo-responsive assemblies, and methods for making and using the same.

In an embodiment, an assembly comprises: a glazing layer; a light absorbing layer; and a thermo-responsive layer between the glazing layer and the light absorbing layer, wherein the thermo-responsive layer comprises a matrix polymer having a glass transition temperature and an inorganic filler having a particle size, wherein refractive indices of the matrix polymer and the inorganic filler differ by less than or equal to 0.05 at 25°C.

In an embodiment, a method of making the assembly comprises: forming the glazing layer; forming the light absorbing layer; and forming the thermo-responsive layer between the glazing layer and the light absorbing layer, wherein the thermo-responsive layer comprises a matrix polymer having a glass transition temperature and an inorganic filler having a particle size, wherein refractive indices of the matrix polymer and the inorganic filler differ by less than or equal to 0.05 at 25°C.

These and other features and characteristics are more particularly described below.

BRIEF DESCRIPTION OF THE DRAWINGS

The following is a brief description of the drawings wherein like elements are numbered alike and which are presented for the purposes of illustrating the exemplary embodiments disclosed herein and not for the purposes of limiting the same.

FIG. 1 is a graphical illustration of the refractive index versus temperature of a matrix polymer and a filler.
FIG. 2 is a schematic illustration of a thermo-responsive assembly at normal use temperatures.
FIG. 3 is a schematic illustration of the thermo-responsive assembly of FIG. 2 at elevated temperatures above the glass transition temperature of the materials used in the thermo-responsive assembly.
FIG. 4 is a graphical illustration of the reflection versus temperature for a sample comprising a thermo-responsive layer as described herein.
FIG. 5 is a graphical illustration of the total reflectance versus wavelength for a sample comprising a thermo-responsive layer as described herein.

DETAILED DESCRIPTION

Disclosed herein are thermo-responsive assemblies comprising: a thermo-responsive layer comprising a transparent matrix polymer filled with an inorganic material (i.e., filler). The inorganic material can have a particle size of less than 10 micrometers ($\mu$m) and a matching refractive index with the matrix polymer (e.g., wherein the refractive indices differ by less than or equal to 0.05 at 25°C). The thermo-responsive assemblies as described herein can have little or no change in the reflection of incident light at temperatures below the glass transition temperature of the matrix polymer, since the refractive index of the materials used in the assemblies changes slowly below the glass transition temperature (Tg) of the matrix polymer. The thermo-responsive assemblies disclosed herein, can however, have increased reflection above the glass transition temperature of the matrix polymer. This is because above the Tg, the refractive index of the transparent matrix polymer generally decreases rapidly, while the refractive index of the inorganic material remains nearly constant. The resulting mismatch in the refractive indices can result in some reflection, with for example, 10% to 20% reflection being sufficient to keep the thermo-responsive assemblies from buckling or other mechanical failures. The term thermo-responsive layer is used herein to refer to a layer that changes its light transmission in response to a temperature change.

Mechanical louvers could be made to open at elevated temperatures and thereby open the module to release heat, but this introduces moving parts, increases complexity and cost, and provides an additional failure mechanism. Many concepts using thermo-responsive materials for thermal control rely on, for example, a phase separation process, an abrupt phase transition, by strongly differing temperature dependencies of the refractive indices of domains and matrix, and/or on, for example, a change in their visible optical properties to cause scattering of light and attenuate the amount of light that can reach an absorber layer (e.g., certain hydrogels and polymer blends with critical temperatures for miscibility, liquid crystals, etc.). However, none of these systems seem practical or cost-effective for a low-cost plastic solar module since they involve components that are fluid or involve difficult to tailor chemical material components.

The thermo-responsive assemblies disclosed herein can comprise a glazing layer, a thermo-responsive layer, and an absorber layer (e.g., a light absorbing layer), and optionally an insulation layer, wherein the thermo-responsive layer can be between the glazing layer and the absorber layer, and the absorber layer can optionally be between the insulation layer and the thermo-responsive layer. Optionally, an insulating layer can be disposed on both sides of the absorber layer. The glazing layer and the thermo-responsive layer can generally be transparent (e.g., have greater than or equal to 85% transmission in the visible and infrared ranges of the electromagnetic spectrum), while the absorber layer can be opaque. The absorber layer can generally be black, meaning that it will not have any transmission. The absorber layer can absorb incoming light and transfer the energy to a circulating fluid, such as air, water, ethylene glycol, etc. The absorber layer can be made of any material with sufficient thermal and hydrolytic stability. The absorber layer can comprise a polysulfone, a modified poly(phenylene oxide), a polyetheretherketone (PEEK), a polyphenylene ether (PPE), a polyimide, or a combination comprising one or more of the foregoing. The insulation layer can comprise a material that reduces the thermal losses of the assembly. Possible insulating layer materials include mineral rue, glass rue, and foam, as well as combinations comprising at least one of the foregoing. The glazing layer can comprise a monolithic or a multiwall sheet. When comprising a multiwall sheet, the glazing layer can comprise, for example, a first wall, a second wall, and ribs disposed therebetween the first wall and the second wall. Additional walls (e.g., a third wall, fourth wall, etc.) and additional ribs dispersed therebetween can also be present. The thermo-responsive layer can comprise a matrix polymer and an inorganic filler. The transmission of a glazing layer can depend on the number of air/polymer interfaces so that a twin wall sheet will have less transmission than a monolithic sheet and a triple wall sheet even less. The effect of the added layers on the energy reaching the absorber layer can be more than compensated for by improved insulation provided by the multiple walls at an optimum number of walls.

The mismatch of the refractive indices of the matrix polymer and inorganic filler at temperatures above the Tg of the matrix polymer can provide reflection of the incoming light, which during stagnation periods, can reduce the temperature extremes experienced by the thermo-responsive assembly, thereby resulting in a lower likelihood of failure (e.g., buckling, warping, thermal expansion, etc.) of the other components of the thermo-responsive assembly. Stated another way, the thermo-responsive assemblies disclosed herein can provide protection to the various other components of the thermo-responsive assembly (i.e., panels) (e.g., solar panels) against failure or damage due to exposure to temperatures above the heat deflection temperature of the components. The thermo-responsive layer can be attached (e.g., laminated, co-extruded, dispersed across) the glazing layer and/or the absorber layer. An air gap can be present between the thermo-responsive layer and the absorber layer. The absorber layer can be attached (e.g., laminated, co-extruded, dispersed across) to the glazing layer.

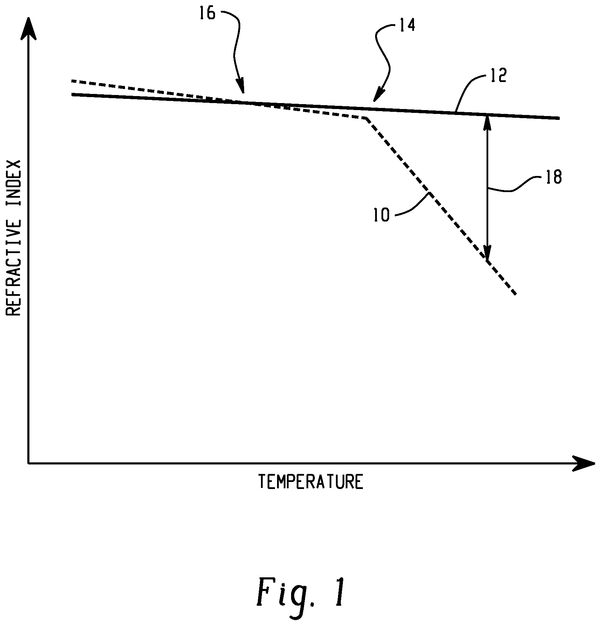

As previously mentioned, a thermo-responsive layer comprising a transparent polymer (i.e., matrix polymer) and an inorganic material (i.e., filler) having a particle size less than or equal to 10 $\mu$m and a matching refractive index with the matrix polymer (e.g., wherein the refractive indices differ by less than or equal to 0.05 at 25°C, specifically, less than or equal to 0.01 at 25°C) can demonstrate little or no change in the reflection of incident light at temperatures below the Tg of the matrix polymer. Although not wishing to be bound by theory, it is believed this occurs because the refractive index of both materials changes relatively slowly below the Tg. However, above the Tg, the density and hence, the refractive index of the matrix polymer can change rapidly, while the refractive index of the inorganic filler can continue to change very slowly. This can result in an increasingly large refractive index mismatch between the matrix polymer and the filler, which can in turn cause some light to be reflected as shown schematically in Figure 1. For example, as illustrated in Figure 1, the matrix polymer 10 and filler 12 can have the same refractive index 16 below the Tg 14, which can give high transmission. Above the Tg 14, however, the refractive indices can be mismatched illustrated by line 18, resulting in reflection. Thus, the amount of light transmitted through the thermo-responsive layer (e.g., light control layer) can be reduced to an increasing degree above Tg, which can lead to a decrease in the stagnation temperatures experienced by the components of the panel.

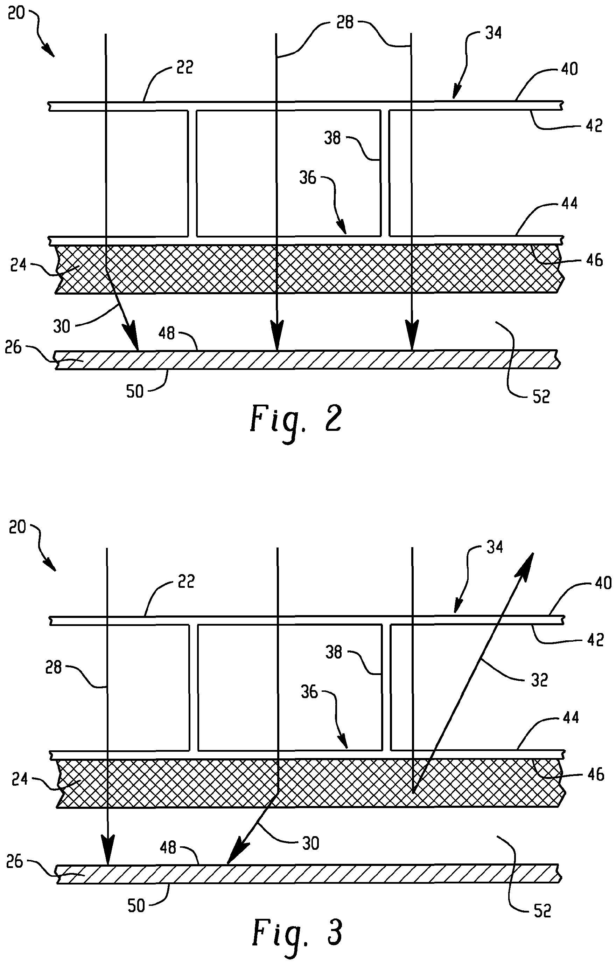

For example, as shown in Figure 2, a thermo-responsive assembly 20 is illustrated that can comprise a glazing layer 22, a thermo-responsive layer 24, and an absorber layer 26. The glazing layer 22 can comprise a solid sheet, a multilayer sheet, or a multiwall sheet. A multiwall sheet having a first wall 34, a second wall 36, and ribs 38 located therebetween is illustrated in Figures 2 and 3. The first wall 34 can have a first wall first surface 40 and a first wall second surface 42, while the second wall 36 can have a second wall first surface 44 and a second wall second surface 46. The absorber layer 26 can comprise an absorber layer first surface 48 and an absorber layer second surface 50. An air gap 52 can be present between the thermo-responsive layer 24 and the absorber layer 26. When the thermo-responsive assembly 20 is exposed to normal use temperatures, the thermo-responsive assembly 20 can experience little or no reflection of the incoming light 28 by the thermo-responsive layer 24. Some haze or forward scattering 30 can be experienced and is acceptable because as shown in Figure 2, the light still reaches the absorber layer 26. At elevated temperatures above the Tg of the matrix polymer, as shown in Figure 3, there is increased scattering 30 and reflection 32, so that less incoming light 28 reaches the absorber layer 26. Since the absorber layer 26 can be partially shaded as shown in Figure 3, the temperature rise of the thermo-responsive assembly 20 can be attenuated.

The thermo-responsive layer 24 can be firmly attached to the glazing layer 22 and/or the absorber layer 26, with either or both of the glazing layer 22 and the absorber layer 26 providing mechanical support for the thermo-responsive layer 24, since the thermo-responsive layer 24 generally becomes mechanically weak at temperatures above the Tg. For example, the thermo-responsive layer 24 can be co-extruded with the absorber layer 26 or with the glazing layer 22 or can be laminated onto the absorber layer 26 or the glazing layer 22. The location of the thermo-responsive layer 24 is not limited and can generally be in any location within the thermo-responsive assembly 20. For example, the thermo-responsive layer 24 can be located on the first wall first surface 40, first wall second surface 42, second wall first surface 44, the second wall second surface 46, or the absorber layer first surface 48. It is not generally desirable for the thermo-responsive layer 24 to be on the absorber layer second surface 50 because no light reaches the absorber layer second surface 50. It can generally be desirable for the thermo-responsive layer 24 to be dispersed across the second wall second surface 46 as shown in Figure 3.

The Tg of the matrix polymer used in the thermo-responsive layer can be adjusted to be approximately equal to the temperature attained during normal working conditions, for example, with the use of plasticizers in the thermo-responsive layer. The polymer used in the thermo-responsive layer can also be selected on the basis of the Tg being approximately equal to the temperature attained during normal working conditions. For example, the Tg can be greater than or equal to 25°C and less than or equal to 100°C, specifically, the Tg can be 50°C to 100°C, more specifically 60°C to 90°C, and even more specifically 65°C to 85°C. The refractive indices of the matrix polymer and the filler can be any value as long as they are matched ± 0.05 at 25°C, for example, the refractive index of the matrix can be 1.4 to 1.75, specifically, 1.45 to 1.7, and more specifically, 1.47 to 1.59. Aliphatic methacrylates generally have a refractive index of 1.47, polycarbonate generally has a refractive index of 1.58, and polystyrene generally has a refractive index of 1.59. In general, it can be desirable for the refractive index of the polymer and the refractive index of the inorganic filler to match to within 0.05, specifically, within 0.01, and more specifically, within 0.005, at 25°C. However, if the refractive index cannot be matched, it can be desirable for the refractive index of the polymer to be 0.005 to 0.02 less than that of the filler.

Possible polymeric resins that can be employed for the matrix polymer used in the thermo-responsive layer can comprise any transparent homopolymer, copolymer, or blend thereof. It can be desirable for the matrix polymer to have optical transparency, a Tg within the desired range (with or without the use of plasticizers), and stability toward light and heat. Examples of desirable polymers include polyesters, polycarbonates, polystyrene, poly(methyl methacrylate) (PMMA), poly(ethyl methacrylate), poly(styrene-co-methyl methacrylate), poly(styrene-co-acrylonitrile) (SAN), poly(methyl methacrylate-co-styrene-co-acrylonitrile) (MMASAN), and other copolymers of styrene, acrylonitrile, various (meth)acrylic acids, and various (meth)acrylates, as well as combinations comprising at least one of the foregoing. For example, the matrix polymer can comprise PMMA or can comprise a combination of PMMA and SAN. The matrix polymer can be selected such that the Tg is in the desired range or can be brought within the desired range with the help of additives such as plasticizers. The refractive index of the matrix polymer can approximately match or have a value slightly lesser than the refractive index of the filler (e.g., be within 0.005 to 0.02 of each other, for example, wherein a difference between the refractive indices of the inorganic filler and the matrix polymer is less than or equal to 0.01; or e.g., the refractive index of the matrix polymer can be 0 to 0.02, specifically, 0 to 0.005 less than the refractive index of the filler) at normal working temperatures so that the total forward transmission of the glazing layer plus the thermo-responsive layer is greater than 80%. Forward transmission generally refers to all light emanating from the non-irradiated surface of the article, i.e., all light that is not reflected, absorbed, or going out the edges. Forward transmission includes both direct transmission along the normal line as well as any light scattered off-normal (haze). Measurement of total forward transmission (or total reflection) is usually accomplished with the use of a spectrometer equipped with an integrating sphere.

The thermo-responsive layer or matrix polymer can also include various additives ordinarily incorporated into polymer compositions of this type, with the proviso that the additive(s) are selected so as to not significantly adversely affect the desired properties of the thermo-responsive layer, in particular, the ability of the thermo-responsive layer to reflect incoming light. Examples of additives that can be included in the matrix polymer or the thermo-responsive layer include optical effects fillers, impact modifiers, fillers, reinforcing agents, antioxidants, heat stabilizers, light stabilizers, ultraviolet (UV) light stabilizers, plasticizers, lubricants, mold release agents, antistatic agents, colorants (such as carbon black and organic dyes), surface effect additives, radiation stabilizers (e.g., infrared absorbing), gamma stabilizers, flame retardants, and anti-drip agents. A combination of additives can be used, for example, a combination of a heat stabilizer, mold release agent, and ultraviolet light stabilizer. In general, the additives are used in the amounts generally known to be effective. Each of these additives can be present in amounts of 0.0001 to 10 weight percent (wt.%), based on the total weight of the thermo-responsive layer.

For example, plasticizing agents can be used to adjust the Tg and the refractive index and additives such as antioxidants and light stabilizers can also be present in the matrix polymer or thermo-responsive layer. Plasticizers for inclusion in the matrix polymer and/or thermo-responsive layer can include benzoate esters of polyols such as penterythritol tetrabenzoate, aliphatic esters, and aryl esters of phosphates such as resorcinol bis(diphenyl phosphate), as well as combinations comprising at least one of the foregoing.

The matrix polymer or thermo-responsive layer can further optionally include a flame retardant. Flame retardants include organic and/or inorganic materials. Organic compounds include, for example, phosphorus, sulphonates, and/or halogenated materials (e.g., comprising bromine chlorine, and so forth, such as brominated polycarbonate). Non-brominated and non-chlorinated phosphorus-containing flame retardant additives can be preferred in certain applications for regulatory reasons, for example, organic phosphates and organic compounds containing phosphorus-nitrogen bonds.

Inorganic flame retardants include, for example, $C_{1-16}$ alkyl sulfonate salts such as potassium perfluorobutane sulfonate (Rimar salt), potassium perfluorooctane sulfonate, tetraethyl ammonium perfluorohexane sulfonate, and potassium diphenylsulfone sulfonate (e.g., KSS); salts such as $Na_2CO_3$, $K_2CO_3$, $MgCO_3$, $CaCO_3$, and $BaCO_3$, or fluoro-anion complexes such as $Li_3AlF_6$, $BaSiF_6$, $KBF_4$, $K_3AlF_6$, $KAlF_4$, $K_2SiF_6$, and/or $Na_3AlF_6$. When present, inorganic flame retardant salts are present in amounts of 0.01 to 10 parts by weight, more specifically 0.02 to 1 parts by weight, based on 100 parts by weight of the thermo-responsive layer.

Light stabilizers and/or ultraviolet light (UV) absorbing stabilizers can also be used. Exemplary UV light absorbing stabilizers include hydroxybenzophenones; hydroxybenzotriazoles; hydroxyphenyl triazines (e.g., 2-hydroxyphenyl triazines); cyanoacrylates; oxanilides; benzoxazinones; dibenzoylresorcinols; 2- (2H-benzotriazol-2-yl)-4-(1,1,3,3-tetramethylbutyl)-phenol (CYASORB™ 5411); 2-hydroxy-4-n-octyloxybenzophenone (CYASORB™ 531); 2-[4,6-bis(2,4-dimethylphenyl)-1,3,5-triazin-2-yl]- 5-(octyloxy)-phenol (CYASORB™ 1164); 2-[4,6-diphenyl-1.3.5-triazin-2-yl]-5-(hexyloxy)-phenol (Tinuvin 1577),2,2'-(1,4- phenylene)bis(4H-3,1-benzoxazin-4-one) (CYASORB™ UV-3638); 1,3-bis[(2-cyano-3,3-diphenylacryloyl)oxy]-2,2-bis[[(2-cyano-3, 3-diphenylacryloyl)oxy]methyl]propane (UVINUL™ 3030); 2,2'-(1,4-phenylene) bis(4H-3,1-benzoxazin-4-one); 1,3-bis[(2-cyano-3,3-diphenylacryloyl)oxy]-2,2-bis[[(2-cyano-3,3-diphenylacryloyl)oxy]methyl]propane; 4,6-dibenzoylresorcinol, nano-size inorganic materials such as titanium oxide, cerium oxide, and zinc oxide, all with a particle size of less than or equal to 100 nanometers, or combinations comprising at least one of the foregoing UV light absorbing stabilizers. UV light absorbing stabilizers are used in amounts of 0.01 to 5 parts by weight, based on 100 parts by weight of the total composition, excluding any filler.

Anti-drip agents can also be used in the matrix polymer or thermo-responsive layer, for example, a fibril forming fluoropolymer such as polytetrafluoroethylene (PTFE). The anti-drip agent can be encapsulated by a rigid copolymer, for example, styrene-acrylonitrile copolymer (SAN). PTFE encapsulated in SAN is known as TSAN. An exemplary TSAN comprises 50 wt.% PTFE and 50 wt.% SAN, based on the total weight of the encapsulated fluoropolymer. The SAN can comprise, for example, 75 wt.% styrene and 25 wt.% acrylonitrile based on the total weight of the copolymer. Anti-drip agents can be used in amounts of 0.1 to 10 parts by weight, based on 100 parts by weight of the total composition of the particular layer, excluding any filler.

Any inorganic filler can be used in the thermo-responsive layer, however, as previously described herein, it can be desirable for the refractive index of the filler to match the refractive index of the matrix polymer (e.g., be within 0.01 of one another) or for the refractive index of the matrix polymer to be 0.005 to 0.02 less than the refractive index of the filler. Generally, the average particle size can be less than or equal to 10 micrometers ($\mu$m), specifically, less than or equal to 7.5 $\mu$m, more specifically less than or equal to 5 $\mu$m, and even more specifically less than or equal to 2 $\mu$m.

Examples of fillers include, but are not limited to, silica, quartz, glass, ceramic particles, gypsum, feldspar, calcium silicate, barium metaborate, mica, clays, magnesium hydroxide, aluminum trihydroxide, Fuller's earth, calcium hydroxide, pyrophyllite, talc, zinc borate, and combinations comprising at least one of the foregoing. Desirable fillers can have high purity and a single component with a well-defined refractive index. Examples of such fillers include, but are not limited to glass, magnesium hydroxide, silica, and quartz.

The amount of light reflected above the Tg of the filler can depend on the loading of the filler, the particle size of the filler, the thickness of the thermo-responsive layer, and the amount of refractive index mismatch between the filler and the polymer matrix. For example, the thickness of the thermo-responsive layer can be 25 $\mu$m to 2,500 $\mu$m (1 mil to 100 mils), specifically, 100 $\mu$m to 1,250 $\mu$m (4 mils to 50 mils), and more specifically 250 $\mu$m to 1,000 $\mu$m (10 mils to 40 mils). The filler can be present in the thermo-responsive layer in amounts of 5 wt.% to 80 wt.%, specifically, 10 wt.% to 60 wt.%, and more specifically, 20 wt.% to 60 wt.%. For example, the thermo-responsive layers disclosed herein comprising a matrix polymer and inorganic filler can have a reflection of greater than or equal to 10% when exposed to temperatures above the Tg of the matrix polymer at a thickness of 25 $\mu$m to 2,500 $\mu$m. As used herein, the reflection can be determined by placing the sample on the reflection port of a Macbeth Coloreye 7000 spectrometer having an integrating sphere to measure total reflection.

The thermo-responsive layer can be fabricated by any means including solvent casting, melt casting, extrusion, blow molding, or co-extrusion onto a substrate. For example, the co-extruded substrate can be a surface of the glazing layer (e.g., the second wall second surface) and/or can be a surface of the absorber layer (e.g., the absorber layer first surface. If fabricated separately, the thermo-responsive layer can be laminated onto the glazing layer or the absorber layer with or without an adhesive layer (e.g., a tie layer).

The thickness of the thermo-responsive assembly can vary depending upon the thickness of the individual components of the thermo-responsive assembly. For example, the glazing layer can comprise a monolithic (e.g., one wall) sheet or a multiwall sheet (e.g., comprising greater than one wall with greater than one air channel (e.g., rib) located therebetween). Generally, the thickness of the glazing layer can be less than or equal to 55 millimeters (mm), specifically, 4 mm to 55 mm, more specifically, 2 mm to 35 mm, even more specifically, 1 mm to 25 mm, and still more specifically, 0.5 mm to 20 mm, as well as any and all ranges and endpoints located therebetween. For example, for a multiwall sheet, the total thickness can be 4 mm to 55 mm, while for a monolithic sheet, the total thickness can be 0.5 mm to 20 mm. The thickness of the thermo-responsive layer can be 25 $\mu$m to 2,500 $\mu$m, specifically, 100 $\mu$m to 1,250 $\mu$m, and more specifically 250 $\mu$m to 1,000 $\mu$m, while the thickness of the absorber layer can be 1 mm to 55 mm, specifically, 2 mm to 35 mm, more specifically, 2 mm to 25 mm, and even more specifically, 3 mm to 15 mm.

Transparency can be desired at temperatures lower than the Tg of the thermo-responsive layer. Percent transmission for laboratory scale samples can be determined using ASTM D1003-00, Procedure B using CIE standard illuminant C. ASTM D-1003-00 (Procedure B, Spectrophotometer, using illuminant C with diffuse illumination with unidirectional viewing) defines transmittance as:

$$\%T = \left(\frac{I}{I_o}\right) x100\%$$

(1)

wherein:

  I = Intensity of the light passing through the test sample
  $I_o$ = Intensity of incident light.

Compared to an assembly of a glazing layer without a thermo-responsive layer, an assembly of glazing layer with a thermo-responsive layer, at temperatures below the Tg of a matrix polymer of the thermo-responsive layer can decrease the total transmission (i.e., direct + diffuse) by less than or equal to 5%, specifically, by less than or equal to 3%, and more specifically, by less than or equal to 2%. The glazing layer and/or the thermo-responsive layer can also desirably have an ultraviolet light stability of 20 years such that they retain greater than or equal to 80% of their light transmission capabilities over that 20 year period.

The thermo-responsive assemblies can likewise be used in any application where, for example, it is desirable to regulate temperature based on light reflection (such as in solar panels, in photovoltaic applications, and in greenhouse applications). The thermo-responsive layer can be applied to a window (such as a vehicle window and a building window, for example, a greenhouse window, an office window, and a house window). The window can be glass and/or polymeric.

The thermo-responsive assemblies as described herein are further illustrated by the following non-limiting examples.

EXAMPLES

Example 1: Disk fabrication procedure

In this example, two grams of matrix polymer and plasticizer, when present, were dissolved in 6 milliliters (mL) of chloroform in a 4 dram screw top vial equipped with a magnetic stir bar. Filler was added and stirred vigorously for at least 3 hours. (The amount of filler was determined by actual weight percentage and not parts by weight. For example, 2 grams (g) of filler and 2 g of polymer gives 50% by weight filler.) The polymer solution was cast onto glass plates and drawn with a 0.254 mm (10 mil) doctor blade. The solvent was evaporated at room temperature and the plates were heated in ovens progressively at 45°C, 65°C, 75°C, 95°C, and 150°C to remove residual volatiles. The polymer films were cut into approx. 2.54 centimeter (cm) (1 inch) squares and floated from the plate with water. The squares were dried at 45°C to 65°C to remove the surface water.
Approximately 1.6 g of the filled polymer was placed in a shimmed compression mold backed with Ferrotype plates, heated to approx. 160°C in a Carver press for 5 minutes at 3,000 kilograms (kg) (3 tons) of pressure, and then allowed to cool to approximately 60°C under a pressure of 3,000 kg (3 tons). This resulted in a disk having a diameter of 5.08 cm (2 inches) and a thickness of 0.254 mm to 0.635 mm (10 mils to 25 mils) depending on the shims. This disk was then laminated to a 0.254 cm (10 mils) thick polycarbonate film by the same procedure. The polycarbonate film provided support during the thermal testing.

Example 2: Reflection measurements

A heating fixture was constructed from a 5.08 cm (2 inch) square silicone heater manufactured by Omega that was sandwiched between two 7.62 cm wide by 7.62 cm long by 0.16 cm thick (3 inch wide by 3 inch long by 0.0625 inch thick) aluminum plates. A third 7.62 cm wide by 7.62 cm long by 0.16 cm thick (3 inch wide by 3 inch long by 0.0625 inch thick) aluminum plate with a 0.3175 cm (0.125 inch) diameter hole in the center was placed on one side, and the assembly was held together by means of a screw in each corner. The side with the hole was painted flat black.
A polycarbonate-backed disk from Example 1 was placed over the hole and secured with strips of Kapton™ tape. A fine thermocouple was melted into the surface of the disk approximately 0.3175 cm from the edge of the hole toward the center. A thin (approximately 1 mm) fluorocarbon "O" ring having a diameter of 3.175 cm (1.25 inches) was attached to the disk surface using Kapton™ tape.
The entire assembly was then placed on the reflection port of a Macbeth Coloreye 7000 spectrometer having an integrating sphere to measure total reflection. The heater was attached to a variable voltage power source and the temperature was increased by approximately 6°C per minute, while reflectance spectra were acquired at 2°C intervals. Upon reaching 130°C, the temperature was stabilized for approximately 5 minutes and then allowed to decrease at a rate of approximately 6°C per minute while spectra were acquired at 2°C intervals. The percentage of reflected light was calculated as the average reflection in the range of 400 nm to 700 nm.

Example 3: Filled Polymers

Table 1 lists the various materials utilized in making the sample compositions. Table 2 lists the compositions for the samples that were made and evaluated following the procedures described with respect to Examples 1 and 2. The composition of the matrix polymer is shown as adding up to 100 parts by weight (e.g., the matrix polymer of Sample 1 comprises 100 wt.% PMMA, while the matrix polymer of Sample 2 comprises 31 wt.% PMMA, 55 wt.% SAN, and 14 wt.% PETB). The loading of filler is shown as true weight % of the total composition (e.g., Sample 2 comprised 40 wt.% filler and 60 wt.% of the matrix polymer). Table 3 demonstrates the amount of total reflection measured (%R) at 70°C, within the normal operating temperature of a module, and also at 130°C, which could be a possible upper limit temperature.

| Table 1: Description of Materials | | |
|---|---|---|
| Material | Description | Supplier and Grade |
| Filler | | |
| Glass-1 | 0.7 μm particle size | Esstech V11-4107 |
| Glass-2 | 0.5 μm particle size | Specialty Glass SP345 |
| Glass-3 | 1.5 μm particle size | Schott G018-361 |
| Mg(OH)$_2$ | 1 μm particle size | Huber Zerogen 100 |

(continued)

| Table 1: Description of Materials | | |
|---|---|---|
| Material | Description | Supplier and Grade |
| Filler | | |
| Ceramic | 0.3 to 14 $\mu$m particle size | 3M W210 |
| Talc | 0.8 $\mu$m particle size | Specialty Minerals Microstuff AG 609 |
| Matrix Polymer Material | | |
| SAN | poly(styrene-co-acrylonitrile), 3:1 monomer ratio | |
| PMMA | poly(methyl methacrylate) | Elvacite 2010 |
| PEMA | poly(ethyl methacrylate) | Elvacite 2043 |
| Copolymer-1 | poly(styrene-co-methyl methacrylate-co-butyl methacrylate) | prepared in-house |
| Plasticizers | | |
| PETB | pentaerythritol tetrabenzoate | Aldrich, recrystallized |
| RDP | resorcinol bis(diphenylphosphate) | Supresta |

| Table 2: Sample Compositions and Properties | | | | |
|---|---|---|---|---|
| Sample No. | Filler | Filler Loading in Thermo-responsive Layer (wt.%) | Matrix Polymer (wt.% in matrix polymer of each material) | Thickness (mm) |
| 1 | None | N/A | 100 PMMA | 0.4572 |
| 2 | Glass-1 | 40 | 31 PMMA, 55 SAN, 14 PETB | 0.4572 |
| 3 | Glass-2 | 40 | 50 PMMA, 36 SAN, 14 PETB | 0.4826 |
| 4 | Glass-3 | 50 | 75 Copolymer-1, 25 PEMA | 0.4572 |
| 5 | Mg(OH)$_2$ | 40 | 70 SAN, 15 PMMA, 15 RDP | 0.4572 |
| 6 | Mg(OH)$_2$ | 50 | 70 SAN, 15 PMMA, 15 RDP | 0.4572 |
| 7 | Mg(OH)$_2$ | 50 | 68.5 SAN, 10.5 PMMA, 21 RDP | 0.508 |
| 8 | Ceramic | 40 | 40 Copolymer-1, 60 PEMA | 0.4572 |
| 9 | Talc | 40 | 20 PMMA, 80 SAN | 0.508 |

| Table 3: Reflection Measurements | | | | | |
|---|---|---|---|---|---|
| Sample No. | Filler | Filler Loading in Thermo-responsive Layer (wt.%) | % Reflection at 70°C | % Reflection at 130°C | % Change |
| 1 | None | N/A | 11.8 | 11.4 | -0.04 |
| 2 | Glass-1 | 40 | 15.7 | 22.4 | +6.7 |
| 3 | Glass-2 | 40 | 20.4 | 28.3 | +7.9 |
| 4 | Glass-3 | 50 | 14.8 | 29.4 | +14.6 |
| 5 | Mg(OH)$_2$ | 40 | 14.7 | 22.4 | +7.7 |
| 6 | Mg(OH)$_2$ | 50 | 15.9 | 24.7 | +8.8 |
| 7 | Mg(OH)$_2$ | 50 | 13.8 | 30.8 | +17.0 |
| 8 | Ceramic | 40 | 18.7 | 24.6 | +5.9 |

(continued)

| Table 3: Reflection Measurements | | | | | |
|---|---|---|---|---|---|
| Sample No. | Filler | Filler Loading in Thermo-responsive Layer (wt.%) | % Reflection at 70°C | % Reflection at 130°C | % Change |
| 9 | Talc | 40 | 16.9 | 19.9 | +3.0 |

Sample 1, containing unfilled PMMA showed only a slight decrease in reflection going from 70°C to 130°C as a result of decreasing refractive index and decreased Fresnel reflection. Samples 2 to 9 showed an increase in reflection as the temperature was increased, ranging from a 3% increase for Sample 9 to a 17% increase for Sample 7.

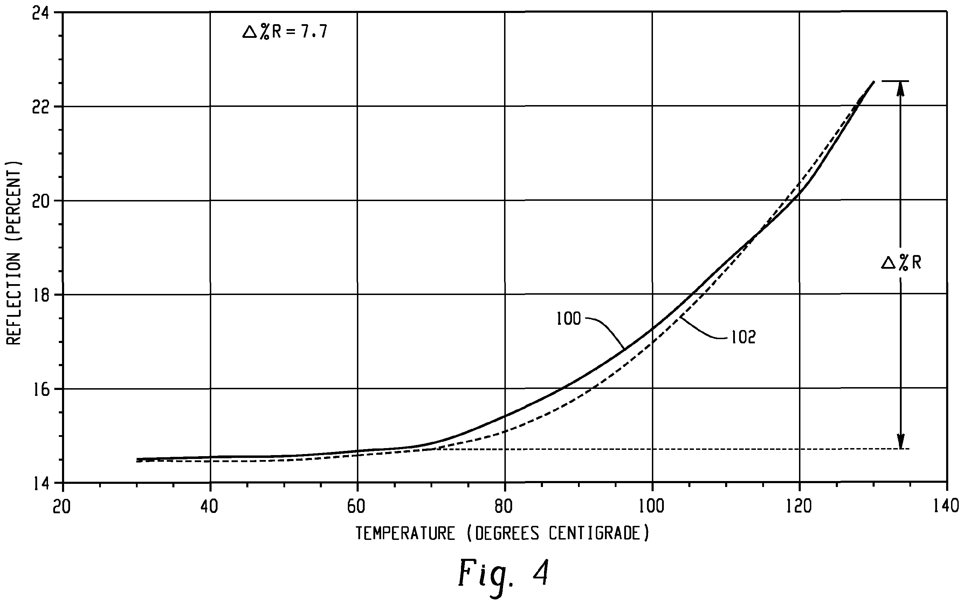

Figure 4 illustrates the temperature (°C) versus reflection (%) for Sample 5. Heat up 100 and cool down 102 are both shown in Figure 4. As can be seen in Figure 4, very little change in reflection is observed at temperatures less than 70°C, while at temperatures greater than 70°C, reflection increases rapidly. There was very little hysteresis, and the change in reflection was immediately reversible as the sample cooled.

Example 4: Reflection Spectra for Sample 7

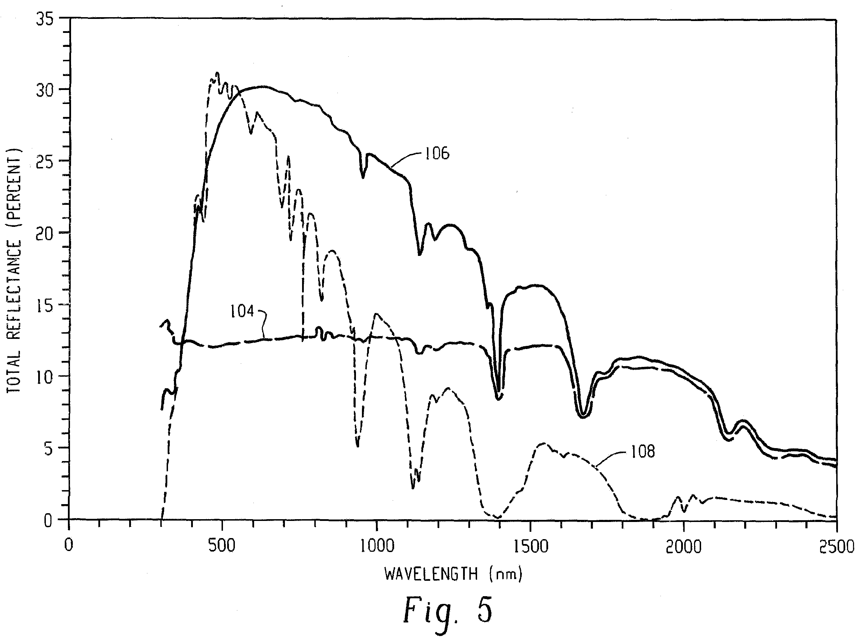

The disk from Sample 7 was mounted on the heater and total reflectance spectra between 300 nanometers (nm) to 2,500 nm were measured using a Cary 5000 UV-VIS-NIR spectrometer equipped with an integrating sphere. Reflectance was measured at 32°C and 130°C. Results are illustrated in Figure 5. As can be seen in Figure 5, the amount of reflection was greatly increased at 130°C (see line 106) compared with 32°C (see line 104), but was not uniformly increased across the wavelength range. The solar spectrum is illustrated by line 108 and shown merely for reference purposes. The simple average of the reflectance does not adequately express performance because the solar spectrum is also not uniform across this range as shown in Figure 5. A more accurate measure is the fraction of solar energy reflected (solar-weighted reflection) shown in Table 4. The difference in simple average reflection in the wavelength range of 400 nm to 2,500 nm was 6.5% going from 32°C to 130°C. However, the difference in reflected solar energy in this wavelength range was 13.1%.

| Table 4: Sample 7 Data | | | | |
|---|---|---|---|---|
| Instrument | Wavelength Range (nm) | % Reflection at 25°C to 30°C | % Reflection at 130°C | % Change |
| Macbeth | 400 to 700 | 12.7 | 30.7 | +18.0 |
| Cary 5000 | 400 to 700 | 12.3 | 28.0 | +15.7 |
| Cary 5000 | 400 to 2,500 | 10.4 | 16.9 | +6.5 |
| Cary 5000 | 400 to 2,500 (solar weighted) | 12.1 | 25.2 | +13.1 |

Example 5: Compression molding of thermo-responsive layer

Molded tiles of 35 g of a thermo-responsive material comprising 32 wt.% SAN, 10.5 wt.% RDP, 7.5 wt.% PMMA, and 50 wt.% $MgOH_2$ were first prepared. Specifically, a mixture of the SAN, RDP, PMMA, and $MgOH_2$ was prepared using a twinscrew extruder. The extrudate was pre-dried for at least 3 hours at 70°C and placed on a metal plate. The sample was covered with aluminum foil and placed inside a 215 x 190 x 0.5 mm mold. A metal plate which was also covered with aluminum foil was placed on top of the mold and the whole assembly was placed in a preheated hot-press (Fontyne Holland) and allowed to melt for 2 minutes at 200°C without any applied pressure. After melting, a pressure of 500 kiloNewton (kN) was applied for 1 minute. The heat was then turned off and the thermo-responsive material was allowed to cool to below the Tg. The molded tile was then laminated with a 0.38 mm polyurethane laminating adhesive onto a polycarbonate twin wall sheet to form the assembly. Several assemblies were prepared.

Example 6: Solar Module Test

The assembly of Example 5 was then installed into a solar thermal collector consisting of an aluminum frame, an aluminum back sheet, a PPE/PS based absorber, and an insulation layer comprising a melamine foam (30 mm thickness) located between the absorber and back sheet.

The collector was then placed in front of a solar simulator (Kinoton SIS unit, collimated light source, three 4500 Watt (W) xenon lamps, radiation 500 to 1500 Watts per square meter (W/m$^2$), projected surface app. 140 x 70 cm, sunlight spectrum) with the cover facing the solar simulator and the sample 8,000 mm from the simulator. A thermocouple, type k, was attached to the absorber surface by welding. The location of sensor was in accordance with ISO 9806-2:8.2 and the data acquisition was performed using IOTECH Personal DAQ equipment.

The stagnation temperature of the solar thermal collector of Example 5 comprising the thermo-responsive layer and insulation was measured with a radiation of 1000 W/m$^2$, at a room temperature of 20 to 25°C, no wind, and an empty collector (i.e., there is no heat transfer fluid in the absorber) to result in a stagnation temperature of 127°C (see Table 5, Sample 6A). In comparison, the stagnation temperature of two assemblies, the first being without an insulation layer and without a thermo-responsive layer laminated onto the cover (see Table 5, Sample 6B) and the second assembly being with the insulation but without thermo-responsive layer laminated onto the cover (see Table 5, Sample 6C), were determined under the same conditions as the solar thermal collector comprising the thermo-responsive layer and the insulation layer (Sample 6A). The resultant stagnation temperatures were 126°C and 161°C, respectively.

| Table 5 | | | |
|---|---|---|---|
| Sample | 6A | 6B | 6C |
| Insulation layer | Yes | No | Yes |
| Thermo-responsive layer | Yes | No | No |
| Stagnation temperature (°C) | 127 | 126 | 161 |
| Initial efficiency | 0.78 | - | 0.82 |

As is well understood in the art, insulation is added to the collector to reduce thermal losses. However, the insulation results in an increase in the stagnation temperature (e.g., see Sample 6C). Table 5 shows that the stagnation temperature was reduced from 161°C to 127°C due to the presence of the thermo-responsive material (using the same amount of isolation in both cases). Hence, the use of the thermo-responsive layer allows the use of the insulation to reduce heat losses, while enabling the use of polymers with an insulation layer present since the stagnation temperature is reduced.

Further shown in Table 5 is the initial efficiency ($\eta_o$). The initial efficiency ($\eta_o$) based on the absorber area (measured according to the ISO 9806-1:1994) reduced from 0.82 to 0.78 when using a thermo-responsive layer laminated onto the cover, where full insulation was used in both cases.

Example 7: Reflection measurements of thermo-responsive samples prepared using different methods

The reflection of an extruded thin film was compared to that of an extruded thin film prepared by solvent casting, Films A and B, respectively. Film A was prepared by film extrusion to result in a 500 micrometer thick film. Film B was prepared following the method of Example 1. Reflection measurements will be taken with temperature following the method of Example 2.

The thermo-responsive assemblies disclosed herein can have increased reflection above the glass transition temperature of the matrix polymer. As previously described, this is because above the Tg, the refractive index of the transparent matrix polymer generally decreases rapidly, while the refractive index of the inorganic material remains nearly constant. The resulting mismatch in the refractive index can result in some reflection, with for example, 10% to 20% reflection being sufficient to keep the thermo-responsive assemblies from buckling or other mechanical failures.

It is to be understood that the matrix polymer and inorganic filler is not limited to those disclosed herein and used in the examples. One skilled in the art will readily be able to select a polymer for the matrix polymer and based upon the refractive index of that polymer chose the inorganic filler accordingly.

Set forth below are some embodiments of connectors and methods of making connectors as disclosed herein.

Embodiment 1: an assembly, comprising: a glazing layer; a light absorbing layer; and a thermo-responsive layer between the glazing layer and the light absorbing layer. The thermo-responsive layer comprises a matrix polymer having a glass transition temperature and an inorganic filler having a particle size. The refractive indices of the matrix polymer and the inorganic filler differ by less than or equal to 0.05 at 25°C.

Embodiment 2: the assembly of Embodiment 1, wherein the glass transition temperature is 25°C to 100°C.

Embodiment 3: the assembly of any of Embodiments 1-2, wherein the glass transition temperature is 60°C to 90°C.

Embodiment 4: the assembly of any of Embodiments 1-3, wherein the glass transition temperature is 65°C to 85°C.

Embodiment 5: the assembly of any of Embodiments 1-4, wherein the particle size is less than or equal to 10 micrometers.

Embodiment 6: the assembly of Embodiment 5, wherein the particle size is less than or equal to 5 micrometers.

Embodiment 7: the assembly of Embodiment 6, wherein the particle size is less than or equal to 2 micrometers.

Embodiment 8: the assembly of any of Embodiments 1-7, wherein the matrix polymer refractive index is 1.4 to 1.75.

Embodiment 9: the assembly of any of Embodiments 1-8, wherein the refractive indices of the inorganic filler and the matrix polymer differ by less than or equal to 0.01 at 25°C.

Embodiment 10: the assembly of any of Embodiments 1-9, wherein the glazing layer comprises a multiwall sheet comprising a first wall, a second wall, and ribs disposed therebetween, wherein the first wall has a first wall first surface and a second wall second surface, and the second wall has a second wall first surface and a second wall second surface, wherein the thermo-responsive layer is attached to the second wall second surface.

Embodiment 11: the assembly of any of Embodiments 1-10, wherein an air gap is present between the thermo-responsive layer and the light absorbing layer.

Embodiment 12: the assembly of any of Embodiments 1-11, wherein the matrix polymer has greater than or equal to 85% transparency measured according to ASTM D1003-00.

Embodiment 13: the assembly of any of Embodiments 1-12, wherein the matrix polymer comprises polyesters, polycarbonates, polystyrene, poly(methyl methacrylate), poly(ethyl methacrylate), poly(styrene-co-methyl methacrylate), poly(styrene-co-acrylonitrile), poly(methyl methacrylate-co-styrene-co-acrylonitrile), copolymers of styrene, acrylonitrile, (meth)acrylic acids, and (meth)acrylates, and combinations comprising at least one of the foregoing.

Embodiment 14: the assembly of any of Embodiments 1-13, wherein the matrix polymer comprises poly(methyl methacrylate), poly(styrene-co-acrylonitrile), or a combination comprising at least one of the foregoing.

Embodiment 15: the assembly of any of Embodiments 1-14, wherein the thermo-responsive layer further comprises a plasticizer.

Embodiment 16: the assembly of Embodiment 15, wherein the plasticizer comprises benzoate esters, aliphatic esters, aryl esters of phosphates, and combinations comprising at least one of the foregoing.

Embodiment 17: the assembly of Embodiment 16, wherein the plasticizer comprises penterythritol tetrabenzoate, resorcinol bis(diphenyl phosphate), and combinations comprising at least one of the foregoing.

Embodiment 18: the assembly of any of Embodiments 1-17, wherein the filler comprises silica, quartz, glass, ceramic particles, gypsum, feldspar, calcium silicate, barium metaborate, mica, clays, magnesium hydroxide, aluminum trihydroxide, Fuller's earth, calcium hydroxide, pyrophyllite, talc, zinc borate, and combinations comprising at least one of the foregoing.

Embodiment 19: the assembly of any of Embodiments 1-18, wherein the filler comprises magnesium hydroxide.

Embodiment 20: the assembly of any of Embodiments 1-18, wherein the filler comprises glass.

Embodiment 21: the assembly of any of Embodiments 1-20, wherein the filler is present in an amount of 5% to 80% by weight.

Embodiment 22: the assembly of any of Embodiments 1-21, wherein the thermo-responsive layer, having a thickness of 25 $\mu$m to 2,500 $\mu$m, has greater than or equal to 10% reflection when exposed to temperatures greater than a glass transition temperature of the matrix polymer.

Embodiment 23: the assembly of any of Embodiments 1-21, further comprising an insulation layer.

Embodiment 24: the assembly of Embodiment 23, wherein the insulating layer comprises at least one of a mineral rue, glass rue, and foam.

Embodiment 25: the assembly of any of Embodiments 23 - 24, wherein the absorber layer is between the insulation layer and the thermo-responsive layer, and optionally, an insulating layer is disposed on both sides of the absorber layer such that there is also an insulating layer between the absorber layer and the thermo-responsive layer.

Embodiment 26: a method of making the assembly of any of Embodiments 1-24, comprising: forming the glazing layer; forming the light absorbing layer; and forming the thermo-responsive layer between the glazing layer and the light absorbing layer. The thermo-responsive layer comprises a matrix polymer having a glass transition temperature and an inorganic filler having a particle size. The refractive indices of the matrix polymer and the inorganic filler differ by less than or equal to 0.05 at 25°C.

Embodiment 27: the method of Embodiment 26, further comprising co-extruding the glazing layer and the thermo-responsive layer.

Embodiment 28: the method of Embodiment 26, further comprising laminating the thermo-responsive layer to a surface of the glazing layer.

Embodiment 29: the method of any of Embodiments 26-28, further comprising co-extruding the light absorbing layer and the thermo-responsive layer.

Embodiment 30: the method of any of Embodiments 26-28, further comprising laminating the thermo-responsive layer to a surface of the light absorbing layer.

All ranges disclosed herein are inclusive of the endpoints, and the endpoints are independently combinable with each other (e.g., ranges of "up to 25 wt.%, or, more specifically, 5 wt.% to 20 wt.%," is inclusive of the endpoints and all intermediate values of the ranges of "5 wt.% to 25 wt.%," etc.). "Combination" is inclusive of blends, mixtures, alloys, reaction products, and the like. Furthermore, the terms "first," "second," and the like, herein do not denote any order, quantity, or importance, but rather are used to determine one element from another. The terms "a" and "an" and "the" herein do not denote a limitation of quantity, and are to be construed to cover both the singular and the plural, unless otherwise indicated herein or clearly contradicted by context. The suffix "(s)" as used herein is intended to include both the singular and the plural of the term that it modifies, thereby including one or more of that term (e.g., the film(s) includes one or more films). Reference throughout the specification to "one embodiment," "another embodiment", "an embodiment," and so forth, means that a particular element (e.g., feature, structure, and/or characteristic) described in connection with the embodiment is included in at least one embodiment described herein, and may or may not be present in other embodiments. In addition, it is to be understood that the described elements may be combined in any suitable manner in the various embodiments.

The average particle size can refer to the average a length measured maximum axis of each of the particles.

All cited patents, patent applications, and other references are incorporated herein by reference in their entirety. However, if a term in the present application contradicts or conflicts with a term in the incorporated reference, the term from the present application takes precedence over the conflicting term from the incorporated reference.

While particular embodiments have been described, alternatives, modifications, variations, improvements, and substantial equivalents that are or may be presently unforeseen may arise to applicants or others skilled in the art. Accordingly, the appended claims as filed and as they may be amended are intended to embrace all such alternatives, modifications variations, improvements, and substantial equivalents.

**Claims**

1. An assembly, comprising:

    a glazing layer;
    a light absorbing layer; and
    a thermo-responsive layer between the glazing layer and the light absorbing layer, wherein the thermo-responsive layer comprises a matrix polymer having a glass transition temperature, said glass transition temperature being approximately equal to the temperature attained during normal working conditions of said assembly, and an inorganic filler having a particle size, wherein the refractive indices of the matrix polymer and the inorganic filler differ by less than or equal to 0.05 at 25°C.

2. The assembly of Claim 1, wherein the glass transition temperature is 25°C to 100°C, or 60°C to 90°C, or 65°C to 85°C.

3. The assembly of any of Claims 1-2, wherein the particle size is less than or equal to 10 micrometers, or less than or equal to 5 micrometers, or less than or equal to 2 micrometers.

4. The assembly of any of Claims 1-3, wherein the matrix polymer refractive index is 1.4 to 1.75.

5. The assembly of any of Claims 1-4, wherein the refractive indices of the inorganic filler and the matrix polymer differ by less than or equal to 0.01 at 25°C.

6. The assembly of any of Claims 1-5, wherein the glazing layer comprises a multiwall sheet comprising a first wall, a second wall, and ribs disposed therebetween, wherein the first wall has a first wall first surface and a first wall second surface and the second wall has a second wall first surface and a second wall second surface, wherein the thermo-responsive layer is attached to the second wall second surface.

7. The assembly of any of Claims 1-6, wherein an air gap is present between the thermo-responsive layer and the light absorbing layer.

8. The assembly of any of Claims 1-7, wherein the matrix polymer has greater than or equal to 85% transparency measured according to ASTM D1003-00.

9. The assembly of any of Claims 1-8, wherein the matrix polymer comprises polyesters, polycarbonates, polystyrene, poly(methyl methacrylate), poly(ethyl methacrylate), poly(styrene-co-methyl methacrylate), poly(styrene-co-acrylonitrile), poly(methyl methacrylate-co-styrene-co-acrylonitrile), copolymers of styrene, acrylonitrile, (meth)acrylic acids, and (meth)acrylates, and combinations comprising at least one of the foregoing, preferably, poly(methyl methacrylate), poly(styrene-co-acrylonitrile), or a combination comprising at least one of the foregoing.

10. The assembly of any of Claims 1-9, wherein the thermo-responsive layer further comprises a plasticizer, and wherein the plasticizer optionally comprises benzoate esters, aliphatic esters, aryl esters of phosphates, and combinations comprising at least one of the foregoing, preferably, penterythritol tetrabenzoate, resorcinol bis(diphenyl phosphate), and combinations comprising at least one of the foregoing.

11. The assembly of any of Claims 1-10, wherein the filler comprises silica, quartz, glass, ceramic particles, gypsum, feldspar, calcium silicate, barium metaborate, mica, clays, magnesium hydroxide, aluminum trihydroxide, Fuller's earth, calcium hydroxide, pyrophyllite, talc, zinc borate, and combinations comprising at least one of the foregoing, preferably, wherein the filler comprises magnesium hydroxide or glass.

12. The assembly of any of Claims 1-11, wherein the thermo-responsive layer, having a thickness of 25 $\mu$m to 2,500 $\mu$m, has greater than or equal to 10% reflection when exposed to temperatures greater than a glass transition temperature of the matrix polymer.

13. A method of making the assembly of any of Claims 1-12, comprising:

forming the glazing layer;
forming the light absorbing layer; and
forming the thermo-responsive layer between the glazing layer and the light absorbing layer;
wherein the thermo-responsive layer comprises a matrix polymer having a glass transition temperature, said glass transition temperature being approximately equal to the temperature attained during normal working conditions of said assembly, and
an inorganic filler having a particle size, wherein the refractive indices of the matrix polymer and the inorganic filler differ by less than or equal to 0.05 at 25°C.

14. The method of Claim 13, further comprising co-extruding the glazing layer and the thermo-responsive layer, or laminating the thermo-responsive layer to a surface of the glazing layer.

15. The method of any of Claims 13-14, further comprising co-extruding the light absorbing layer and the thermo-responsive layer or laminating the thermo-responsive layer to a surface of the light absorbing layer.

**Patentansprüche**

1. Eine Anordnung, die folgendes umfasst:

eine Glasurschicht;
eine lichtabsorbierende Schicht; und
eine thermo-reagierende Schicht zwischen der Glasurschicht und der lichtabsorbierenden Schicht, worin die thermo-reagierende Schicht ein Matrixpolymer umfasst mit einer Glasübergangstemperatur, wobei die Glasübergangstemperatur ungefähr gleich zu der Temperatur ist, die während normalen Arbeitsumständen der Anordnung erreicht wird, und
einen anorganischen Füllstoff mit einer Partikelgröße, worin sich die Brechzahlen des Matrixpolymers und des anorganischen Füllstoffs um weniger als oder gleich 0,05 bei 25°C unterscheiden.

2. Die Anordnung gemäß Anspruch 1, worin die Glasübergangstemperatur 25°C bis 100°C, oder 60°C bis 90°C, oder 65°C bis 85°C ist.

3. Die Anordnung gemäß irgendeinem der Ansprüche 1-2, worin die Partikelgröße geringer als oder gleich 10 Mikrometer ist, oder geringer als oder gleich 5 Mikrometer, oder geringer als oder gleich 2 Mikrometer.

4. Die Anordnung gemäß irgendeinem der Ansprüche 1-3, worin die Brechzahl des Matrixpolymers 1.4 bis 1.75 ist.

5. Die Anordnung gemäß irgendeinem der Ansprüche 1-4, worin sich die Brechzahlen des anorganischen Füllstoffs und des Matrixpolymers um weniger als oder gleich 0,01 bei 25°C unterscheiden.

6. Die Anordnung gemäß irgendeinem der Ansprüche 1-5, worin die Glasurschicht eine mehrlagige Folie umfasst, umfassend eine erste Lage, eine zweite Lage, und dazwischen angeordnet Rippen, worin die erste Lage eine erste Lage erste Oberfläche und eine erste Lage zweite Oberfläche hat, und die zweite Lage hat eine zweite Lage erste Oberfläche und eine zweite Lage zweite Oberfläche, worin die thermo-reagierende Schicht an die zweite Lage zweite Oberfläche angeheftet ist.

7. Die Anordnung gemäß irgendeinem der Ansprüche 1-6, worin ein Luftspalt zwischen der thermo-reagierenden Schicht und der lichtabsorbierenden Schicht vorhanden ist.

8. Die Anordnung gemäß irgendeinem der Ansprüche 1-7, worin das Matrixpolymer mehr als oder gleich 85% Transparenz besitzt, gemessen nach ASTM D1003-00.

9. Die Anordnung gemäß irgendeinem der Ansprüche 1-8, worin das Matrixpolymer Polyester, Polycarbonate, Polystyren, Poly(methylmethacrylat), Poly(ethylmethacrylat), Poly(styren-co-methylmethacrylat), Poly(styren-co-acrylonitril), Poly(methylmethacrylat-co-styren-co-acrylonitril), Copolymere von Styren, Acrylonitril, (Meth)acrylsäuren, und (Meth)acrylate und Kombinationen umfassend mindestens eines der zuvor genannten umfasst, vorzugsweise Poly(methylmethacrylat), Poly(styren-co-acrylonitril), oder eine Kombination umfassend mindestens eines der zuvor genannten.

10. Die Anordnung gemäß irgendeinem der Ansprüche 1-9, worin die thermo-reagierende Schicht weiter einen Weichmacher umfasst, und worin der Weichmacher wahlweise Benzoatester, aliphatische Ester, Arylester von Phosphaten, und Kombinationen umfassend mindestens einen der zuvor genannten umfasst, vorzugsweise Penterythritoltetrabenzoat, Resorcinol bis(Diphenylphosphat), und Kombinationen umfassend mindestens einen der zuvor genannten.

11. Die Anordnung gemäß irgendeinem der Ansprüche 1-10, worin der Füllstoff Siliziumdioxid, Quartz, Glas, keramische Partikel, Gips, Feldspat, Kalziumsilikat, Bariummetaborat, Glimmer, Tone, Magnesiumhydroxid, Aluminiumtrihydroxid, Fullererde, Kalziumhydroxid, Pyrophyllit, Talkum, Zinkborat, und Kombinationen umfassend mindestens einen der zuvor genannten umfasst, vorzugsweise worin der Füllstoff Magnesiumhydroxid oder Glas umfasst.

12. Die Anordnung gemäß irgendeinem der Ansprüche 1-11, worin die thermo-reagierende Schicht mit einer Dicke von 25 $\mu$m bis 2,500 $\mu$m mehr als oder gleich 10% Reflektierung zeigt, wenn sie gegenüber Temperaturen ausgesetzt wird, die größer sind als eine Glasübergangstemperatur des Matrixpolymers.

13. Ein Verfahren zur Herstellung der Anordnung gemäß irgendeinem der Ansprüche 1-12, das folgendes umfasst:

    Bilden der Glasurschicht;
    Bilden der lichtabsorbierenden Schicht; und
    Bilden der thermo-reagierenden Schicht zwischen der Glasurschicht und der lichtabsorbierenden Schicht; worin die thermo-reagierende Schicht ein Matrixpolymer umfasst mit einer Glasübergangstemperatur, wobei die Glasübergangstemperatur ungefähr gleich der Temperatur ist, die während normalen Arbeitsbedingungen der Anordnung erreicht wird, und einen anorganischen Füllstoff mit einer Partikelgröße, worin sich die Brechzahlen des Matrixpolymers und des anorganischen Füllstoffs um weniger als oder gleich 0,05 bei 25°C unterscheiden.

14. Das Verfahren gemäß Anspruch 13, weiter umfassend das Co-Extrudieren der Glasurschicht und der thermo-reagierenden Schicht, oder das Laminieren der thermo-reagierenden Schicht auf eine Oberfläche der Glasurschicht.

15. Das Verfahren gemäß irgendeinem der Ansprüche 13-14, weiter umfassend das Co-Extrudieren der lichtabsorbierenden Schicht und der thermo-reagierenden Schicht oder das Laminieren der thermo-reagierenden Schicht auf eine Oberfläche der lichtabsorbierenden Schicht.

**Revendications**

1. Ensemble, comprenant :

    une couche de vitrage ;
    une couche d'absorption de lumière ; et

une couche thermosensible entre la couche de vitrage et la couche d'absorption de lumière, la couche thermosensible comprenant un polymère formant matrice ayant une température de transition vitreuse, ladite température de transition vitreuse étant approximativement égale à la température atteinte dans les conditions de fonctionnement normales dudit ensemble, et

une charge inorganique ayant une taille de particule, les indices de réfraction du polymère formant matrice et de la charge inorganique différant d'une valeur inférieure ou égale à 0,05 à 25 °C.

2. Ensemble selon la revendication 1, dans lequel la température de transition vitreuse est de 25 °C à 100 °C, ou de 60 °C à 90 °C, ou de 65 °C à 85 °C.

3. Ensemble selon l'une quelconque des revendications 1 à 2, dans lequel la taille de particule est inférieure ou égale à 10 micromètres, ou inférieure ou égale à 5 micromètres, ou inférieure ou égale à 2 micromètres.

4. Ensemble selon l'une quelconque des revendications 1 à 3, dans lequel l'indice de réfraction du polymère formant matrice est de 1,4 à 1,75.

5. Ensemble selon l'une quelconque des revendications 1 à 4, dans lequel les indices de réfraction de la charge inorganique et du polymère formant matrice diffèrent d'une valeur inférieure ou égale à 0,01 à 25 °C.

6. Ensemble selon l'une quelconque des revendications 1 à 5, dans lequel la couche de vitrage comprend une feuille multi-parois comprenant une première paroi, une deuxième paroi, et des nervures disposées entre celles-ci, dans lequel la première paroi présente une première surface de la première paroi et une deuxième surface de la première paroi et la deuxième paroi présente une première surface de la deuxième paroi et une deuxième surface de la deuxième paroi, la couche thermosensible étant fixée à la deuxième surface de la deuxième paroi.

7. Ensemble selon l'une quelconque des revendications 1 à 6, dans lequel un entrefer est présent entre la couche thermosensible et la couche d'absorption de lumière.

8. Ensemble selon l'une quelconque des revendications 1 à 7, dans lequel le polymère formant matrice a une transparence supérieure ou égale à 85 % mesurée selon la norme ASTM D1003-00.

9. Ensemble selon l'une quelconque des revendications 1 à 8, dans lequel le polymère formant matrice comprend les polyesters, les polycarbonates, le polystyrène, le poly(méthylméthacrylate), le poly(éthylméthacrylate), le poly(styrène-co-méthylméthacrylate), le poly(styrène-co-acrylonitrile), le poly(méthylméthacrylate-co-styrène-co-acrylonitrile), les copolymères de styrène, d'acrylonitrile, d'acides (méth)acryliques et de (méth)acrylates, et les combinaisons comprenant au moins l'un des composés précédents, de préférence le poly(méthylméthacrylate), le poly(styrène-co-acrylonitrile), ou une combinaison comprenant au moins l'un des composés précédents.

10. Ensemble selon l'une quelconque des revendications 1 à 9, dans lequel la couche thermosensible comprend en outre un plastifiant, et dans lequel le plastifiant comprend facultativement les esters de benzoate, les esters aliphatiques, les esters aryliques de phosphates, et les combinaisons comprenant au moins l'un des composés précédents, de préférence le tétrabenzoate de pentérythritol, le bis(diphénylphosphate) de résorcinol, et les combinaisons comprenant au moins l'un des composés précédents.

11. Ensemble selon l'une quelconque des revendications 1 à 10, dans lequel la charge comprend la silice, le quartz, le verre, les particules de céramique, le gypse, le feldspath, le silicate de calcium, le métaborate de baryum, le mica, les argiles, l'hydroxyde de magnésium, le trihydroxyde d'aluminium, la terre à foulon, l'hydroxyde de calcium, la pyrophyllite, le talc, le borate de zinc, et les combinaisons comprenant au moins l'un des composés précédents, de préférence dans lequel la charge comprend l'hydroxyde de magnésium ou le verre.

12. Ensemble selon l'une quelconque des revendications 1 à 11, dans lequel la couche thermosensible, ayant une épaisseur de 25 $\mu$m à 2 500 $\mu$m, a une réflexion supérieure ou égale à 10 % lorsqu'elle est exposée à des températures supérieures à une température de transition vitreuse du polymère formant matrice.

13. Procédé de fabrication de l'ensemble selon l'une quelconque des revendications 1 à 12, comprenant :

la formation de la couche de vitrage ;
la formation de la couche d'absorption de lumière ; et

la formation de la couche thermosensible entre la couche de vitrage et la couche d'absorption de lumière ;
la couche thermosensible comprenant un polymère formant matrice ayant une température de transition vitreuse, ladite température de transition vitreuse étant approximativement égale à la température atteinte dans les conditions de fonctionnement normales dudit ensemble, et
une charge inorganique ayant une taille de particule, les indices de réfraction du polymère formant matrice et de la charge inorganique différant d'une valeur inférieure ou égale à 0,05 à 25 °C.

**14.** Procédé selon la revendication 13, comprenant en outre la co-extrusion de la couche de vitrage et de la couche thermosensible, ou l'application de la couche thermosensible sur une surface de la couche de vitrage.

**15.** Procédé selon l'une quelconque des revendications 13 à 14, comprenant en outre la co-extrusion de la couche d'absorption de lumière et de la couche thermosensible ou l'application de la couche thermosensible sur une surface de la couche d'absorption de lumière.

*Fig. 1*

*Fig. 2*

*Fig. 3*

Fig. 4

EP 2 970 692 B1

Fig. 5

EP 2 970 692 B1